(19) **Europäisches Patentamt / European Patent Office / Office européen des brevets**

(11) **EP 4 564 631 A1**

(12) # DEMANDE DE BREVET EUROPEEN

(43) Date de publication:
**04.06.2025 Bulletin 2025/23**

(21) Numéro de dépôt: **24215019.1**

(22) Date de dépôt: **25.11.2024**

(51) Classification Internationale des Brevets (IPC):
**H02J 3/00** (2006.01)   **G01R 31/08** (2020.01)
**H02J 13/00** (2006.01)

(52) Classification Coopérative des Brevets (CPC):
**H02J 13/00002; G01R 31/086; H02J 3/00;**
H02J 2203/20

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **01.12.2023 FR 2313455**

(71) Demandeur: **Electricité de France**
**75008 Paris (FR)**

(72) Inventeurs:
• **CUSSIGH, Nicolas**
  **92190 MEUDON (FR)**
• **LEMBEYE, Rémi**
  **94250 GENTILLY (FR)**

(74) Mandataire: **Plasseraud IP**
**104 Rue de Richelieu**
**CS92104**
**75080 Paris Cedex 02 (FR)**

(54) **OPTIMISATION DU PLACEMENT DE CAPTEURS DE TENSION SUR UN RÉSEAU ÉLECTRIQUE PAR RECUIT SIMULÉ**

(57)      L'invention concerne un procédé d'optimisation du positionnement de capteurs dans un réseau électrique comprenant un ensemble de noeuds, les capteurs étant configurés pour fournir des mesures de variables électriques du réseau. Selon l'invention, un tel procédé comprend :

a. une initialisation (E1) du positionnement des capteurs, par tirage aléatoire d'une solution initiale correspondant à un ensemble de positions des capteurs au sein des noeuds du réseau, et d'un paramètre de température initiale $T_0$,

b. une évaluation (E2) d'une performance de la solution initiale, et

c. au moins une itération d'évolution du positionnement desdits capteurs, produisant à partir d'une solution de positionnement de rang $i \geq 0$ une solution de positionnement de rang i+1, par algorithme de recuit simulé.

Un tel procédé comprend également un placement (E8) des capteurs au sein du réseau aux positions déterminées par la solution de positionnement de rang i+1 obtenue à l'issue des itérations d'évolution.

[Fig. 2]

EP 4 564 631 A1

## Description

### Domaine technique

La présente divulgation relève du domaine de la conduite des réseaux de distribution et de transport d'électricité. Elle s'applique notamment, mais non exclusivement, à l'estimation d'état de tels réseaux, qui est notamment utile pour opérer un réglage de tension en présence de production électrique décentralisée.

### Technique antérieure

Le réglage de tension d'un réseau de distribution en présence de production décentralisée nécessite une estimation fiable des tensions en tout noeud du réseau. La tension en tout noeud du réseau peut notamment être déterminée en appliquant les lois de l'électrotechnique à des mesures réelles fournies par des capteurs de tension positionnés sur des noeuds du réseau de distribution et à des pseudo-mesures calculées à partir d'un modèle de charge des consommateurs et des postes de transformation HTA/BT non instrumentés par des capteurs.

La fiabilité de l'estimation des tensions dépend directement du nombre de capteurs en réseau. Si le nombre de capteurs en réseau est trop faible, il n'est pas possible de garantir le fonctionnement d'un procédé de réglage des tensions car la précision d'estimation de la tension en tout noeud du réseau ne sera pas conforme aux contraintes techniques, à savoir un écart maximum de 1% entre l'estimation de la tension et la valeur réelle, non connue, de cette tension. Or il n'est pas possible, pour des raisons de coût, d'instrumenter de très nombreux points de mesure sur un réseau de distribution.

Il est donc important, étant donné un nombre limité de capteurs de tension à disposition d'un exploitant du réseau, d'optimiser leur placement sur le réseau pour garantir une bonne estimation d'état.

A ce jour, le placement des capteurs est souvent réalisé à dire d'expert, ce dernier utilisant ses connaissances électrotechniques pour obtenir un placement efficient. Ce placement peut être pertinent, mais il n'est pas toujours optimal, notamment parce qu'il est impossible pour l'expert de tester de manière exhaustive toutes les combinaisons de positionnements de capteurs possibles sur le réseau. En outre, un tel placement de capteurs à dire d'expert est souvent long à mettre en place. Une telle méthode n'est en outre pas généralisable en cas de passage à l'échelle, dans le cas où l'exploitant du réseau de distribution souhaiterait placer des capteurs pour tous les départs du réseau, ce qui nécessiterait de faire appel à de très nombreux experts. On rappelle en effet qu'à la connexion entre le réseau de transport et le réseau de distribution, se situe un poste HTB/HTA, constitué d'un ou de plusieurs transformateurs derrière chacun desquels partent plusieurs lignes permettant de relier plusieurs consommateurs et producteurs. On appelle « départ » une de ces lignes et tout ce qu'elle relie.

Le document de brevet FR 3 006 818 A1 au nom du Demandeur décrit un procédé itératif permettant de déterminer un nombre minimum de capteurs à installer dans un réseau et leur position pour garantir une estimation des tensions en tous noeuds du réseau qui soit suffisamment fiable. Un tel procédé repose sur une comparaison d'une première série de valeurs simulées de variables électriques du réseau, par simulation de son fonctionnement, et d'une deuxième série de valeurs estimées de ces variables, correspondant à des mesures de capteurs théoriques, obtenues par estimation d'état à partir d'un sous-ensemble de la première série de valeurs simulées. En cas de divergence inférieure à une valeur seuil, des capteurs sont installés dans le réseau aux emplacements des capteurs théoriques. Dans le cas contraire, le procédé est réitéré en faisant évoluer le sous-ensemble de valeurs correspondant à des mesures de capteurs théoriques.

Un tel procédé est intéressant en ce qu'il permet de garantir la fiabilité de l'estimation d'état associée à un positionnement donné de capteurs dans le réseau. Cependant, il ne permet pas de garantir que ce positionnement soit optimal. En outre, la recherche d'un positionnement adéquat peut s'avérer coûteuse en temps, compte tenu du caractère itératif du procédé, qui nécessite d'explorer successivement et aléatoirement un ensemble de configurations de positions de capteurs de tension, ce qui peut s'avérer fastidieux.

Le document de brevet CN107563550A propose une méthode d'estimation d'état en temps réel dans un réseau de distribution d'électricité, comprenant notamment des producteurs d'énergie éolienne et d'énergie photovoltaïque. Cette méthode d'estimation d'état repose sur l'utilisation d'un ensemble de capteurs de tension. Les mesures effectuées par ces capteurs permettent de reconstituer les tensions sur l'ensemble du réseau.

Ce document évoque en outre brièvement l'idée d'utiliser un algorithme génétique pour optimiser le positionnement des capteurs de tension dans le réseau de distribution électrique. On rappelle que les algorithmes génétiques appartiennent à la famille des algorithmes évolutionnistes. Leur but est d'obtenir une solution approchée à un problème d'optimisation, lorsqu'il n'existe pas de méthode exacte ou que la solution est inconnue, pour le résoudre en un temps raisonnable. Les algorithmes génétiques utilisent la notion de sélection naturelle et l'appliquent à une population de solutions potentielles au problème donné (en l'espèce, les positions de capteurs de tensions évaluées).

Cette méthode décrite d'optimisation de la position des capteurs de tension présente plusieurs inconvénients. En effet, elle ne permet notamment pas d'obtenir une solution au problème du positionnement optimal des capteurs de

**EP 4 564 631 A1**

tension avec un nombre contraint de capteurs de tension à disposition par l'exploitant du réseau. Or, ces capteurs sont souvent en nombre limité et, il est important de tenir compte de cette contrainte opérationnelle lors de l'optimisation de leur placement en différents noeuds du réseau. En outre, cette méthode ne garantit pas une exploration suffisante de l'espace des solutions possibles, et peut donc converger vers un optimum local, qui donnera, en terme d'estimation d'état, une réponse sous-optimale en termes de fiabilité et de précision. De plus, cette méthode apparaît sous-optimale en ce qu'elle ne tient pas compte de la topologie du réseau considéré. Enfin, le temps de calcul nécessaire selon cette méthode est trop long.

Il existe donc un besoin d'une technique d'optimisation du positionnement de capteurs dans un réseau électrique qui ne présente pas ces différents inconvénients de l'art antérieur.

## Résumé

La présente divulgation vient améliorer la situation.

Il est proposé un procédé d'optimisation du positionnement de capteurs dans un réseau électrique comprenant un ensemble de noeuds, les capteurs étant configurés pour fournir des mesures de variables électriques du réseau. Un tel procédé comprend :

 a. une initialisation du positionnement des capteurs, par tirage aléatoire d'une solution initiale correspondant à un ensemble de positions des capteurs au sein de l'ensemble de noeuds du réseau, et d'un paramètre de température initiale $T_0$,

 b. une évaluation d'une performance de ladite solution initiale, et

 c. au moins une itération d'évolution du positionnement desdits capteurs, produisant à partir d'une solution de positionnement de rang $i \geq 0$ une solution de positionnement de rang i+1, ladite évolution comprenant :

  i. une détermination d'une solution voisine de la solution de rang i, comprenant un ensemble de positions desdits capteurs choisies dans un voisinage des positions de la solution de rang i, un voisinage d'une position comprenant l'ensemble des noeuds situés à une distance inférieure ou égale à un de ladite position ;

  ii. une évaluation d'une performance de la solution voisine déterminée, et d'une différence, $\Delta E$, entre la performance de la solution voisine et la performance de la solution de rang i, et :

   1. si la différence $\Delta E$ est négative ou nulle, la solution voisine est conservée en tant que solution de positionnement de rang i+1 ;

   2. si la différence $\Delta E$ est positive, la solution voisine est conservée en tant que solution de positionnement de rang i+1 avec une probabilité égale à $e^{\frac{\Delta E}{T_i}}$ , où $T_i$ est une valeur du paramètre de température au rang i ;

  iii. une diminution du paramètre de température selon l'équation $T_{i+1} = \alpha T_i$, où $\alpha$ est un coefficient déterminé et strictement inférieur à 1, tant que $T_{i+1}$ est supérieure à un paramètre de température minimale déterminée $T_{min}$ ;

et le procédé comprend un placement des capteurs au sein du réseau aux positions déterminées par la solution de positionnement de rang i+1 obtenue à l'issue de ladite au moins une itération d'évolution.

Selon un autre aspect, il est proposé un programme informatique comportant des instructions pour la mise en oeuvre de tout ou partie d'un procédé tel que défini dans les présentes lorsque ce programme est exécuté par un processeur. Selon un autre aspect, il est proposé un support d'enregistrement non transitoire, lisible par un ordinateur, sur lequel est enregistré un tel programme.

Les caractéristiques exposées dans les paragraphes suivants peuvent, optionnellement, être mises en oeuvre, indépendamment les unes des autres ou en combinaison les unes avec les autres :

L'initialisation comprend :

- un tirage aléatoire de k≥2 solutions comprenant chacune un même nombre déterminé de capteurs ;
- une détermination d'une solution voisine de chacune des k solutions ;
- une évaluation d'une performance de chacune des k solutions, $E_{sol,k}$ et de chacune de leurs solutions voisines, $E_{vois,k}$ ;

3

- un calcul d'un écart moyen espéré selon l'équation : $\Delta E_{esp} = \frac{\sum_1^k (E_{sol,k} - E_{vois,k})}{k}$

et le paramètre de température initiale est initialisé à $T_0$ = 100 * $\Delta E_{esp}$ et le paramètre de température minimale est déterminé par $T_{min}$ = 0,01 * $\Delta E_{esp}$.

La détermination d'une solution voisine de la solution de rang i comprend, pour chaque position dans la solution de rang i, un tirage aléatoire équiprobable d'une position située dans son voisinage, et la solution voisine diffère de la solution de rang i pour au moins une de ses positions.

Si le voisinage d'une position comprend au moins un noeud interdit, le voisinage de la position est complété par un voisinage du ou des noeud(s) interdit(s).

L'évaluation d'une performance d'une solution met en oeuvre un calcul d'une fonction objectif définie par :

$$Perf(sol) = \sum_{n=1}^N \max \left( \left| \frac{loadflow(n) - estimation(n,sol)}{loadflow(n)} \right| \right)$$

, où *Perf* désigne la performance de la solution *sol, N* est un nombre de points de fonctionnement étudiés, *loadflow*(*n*) associe à un point de fonctionnement *n* la valeur des variables électriques des noeuds dudit réseau calculées à partir de données de production et de consommation connues pour ledit réseau et *estimation*(*n, sol*) désigne pour le point de fonctionnement *n* la valeur des variables électriques des noeuds dudit réseau estimées à partir des mesures fournies par lesdits capteurs placés à l'ensemble de positions définies par la solution *sol* et en ce qu'une solution présente une performance d'autant meilleure qu'elle minimise la valeur de ladite fonction objectif calculée.

**Brève description des dessins**

D'autres caractéristiques, détails et avantages apparaîtront à la lecture de la description détaillée ci-après, et à l'analyse des dessins annexés, sur lesquels :

**Fig. 1**

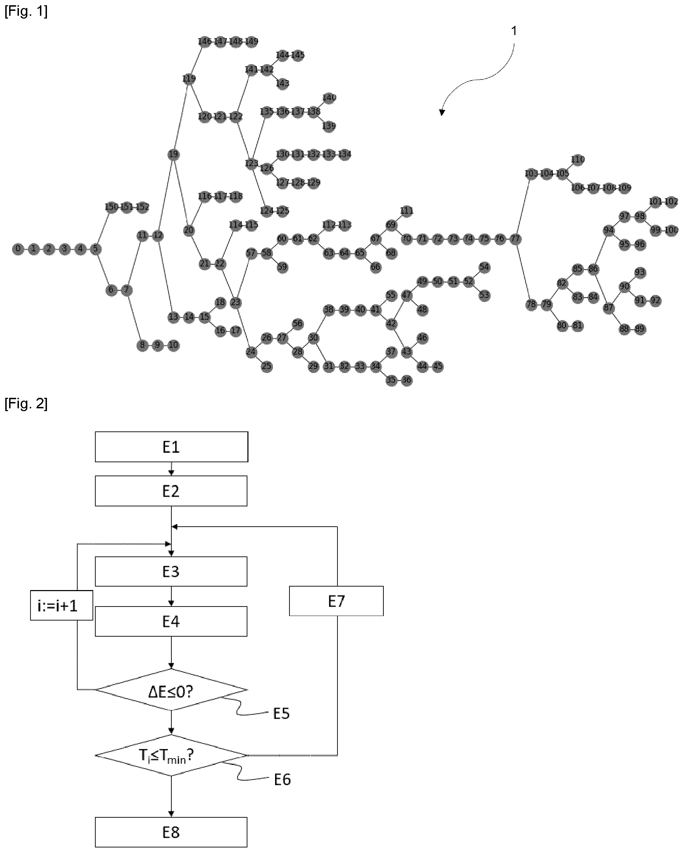

[Fig. 1] illustre un réseau de distribution électrique selon un mode de réalisation.

**Fig. 2**
[Fig. 2] illustre un procédé d'optimisation du positionnement de capteurs de tension dans un réseau de distribution pour le réglage de tension en présence de production décentralisée selon un mode de réalisation.

**Fig. 3**

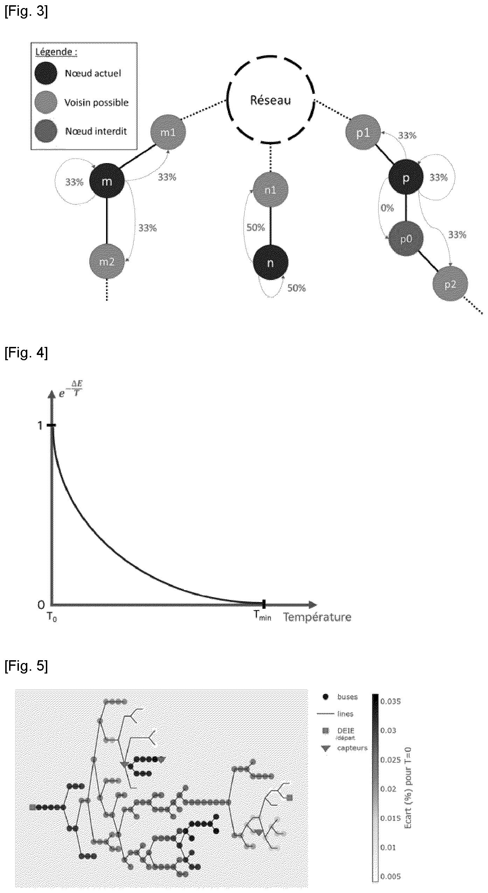

[Fig. 3] montre un schéma synthétique simplifié du réseau de la figure 1 pour illustrer le principe de détermination de solutions voisines selon un mode de réalisation.

**Fig. 4**
[Fig. 4] montre une courbe représentative de la règle de Metropolis illustrant une probabilité d'évolution des solutions selon un mode de réalisation.

**Fig. 5**
[Fig. 5] montre un exemple de placement de capteurs obtenu par application du procédé d'optimisation de la figure 2 selon un mode de réalisation.

**Fig. 6**

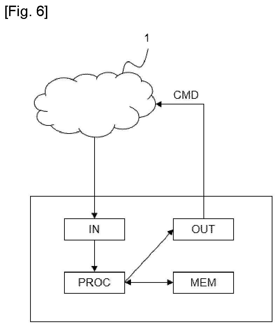

[Fig. 6] illustre schématiquement la structure d'un dispositif d'optimisation du positionnement de capteurs configuré pour mettre en oeuvre le procédé selon la figure 2.

**Description des modes de réalisation**

Il est maintenant fait référence à la figure 1, qui illustre un réseau électrique référencé 1. Un tel réseau 1 peut être un réseau de transport, qui achemine l'électricité depuis les centres de production jusqu'aux grands sites industriels et aux réseaux de distribution, ou un réseau de distribution qui permet de transporter l'énergie électrique à l'échelle locale, des centres de distribution vers le client final.

Un tel réseau 1 comprend un ensemble de noeuds organisés selon une structure arborescente depuis un noeud source. Chaque ramification de la topologie du réseau comprend un ou plusieurs noeuds, qui peuvent correspondre à des postes HTA/BT, des organes de manoeuvre, des consommateurs ou encore des producteurs décentralisés. Dans l'exemple de la figure 1, le noeud source porte le numéro « 0 », et chacun des noeuds de la structure arborescente porte un numéro, qui s'incrémente de proche en proche le long d'une branche de l'arborescence. Le réseau électrique de la figure 1 comprend par exemple 153 noeuds.

On suppose que l'on dispose de certaines données et informations sur le réseau électrique 1, et notamment :

- la topologie du départ étudié, avec notamment la position des capteurs déjà présents et des Dispositifs d'Echange d'informations d'Exploitation (DEIE), qui permettent la téléconduite et la télésurveillance des installations de production décentralisées ;
- des données de production et de consommation sur le réseau 1. Ces données doivent être suffisamment nombreuses et variées pour garantir une certaine exhaustivité des situations rencontrées sur le réseau 1.

Connaissant ces différents éléments, on propose, dans un mode de réalisation, d'optimiser le placement de capteurs dans le réseau 1 selon un procédé qui repose sur l'utilisation d'une méthode d'optimisation dite de recuit simulé, dont le schéma synoptique général est illustré en figure 2.

Une telle méthode d'optimisation par recuit simulé s'appuie sur l'algorithme de Metropolis-Hastings, qui permet de décrire l'évolution d'un système thermodynamique. Par analogie avec le processus physique, la fonction objectif que l'on cherche à minimiser dans le cadre de l'optimisation est assimilée à l'énergie E du système considéré. On introduit également un paramètre fictif, qu'on appelle la température T du système. Partant d'un état donné du système, en le modifiant, on obtient un état voisin, qui peut améliorer le critère que l'on cherche à optimiser (il fait alors baisser l'énergie du système) ou qui peut le dégrader. Si on accepte un état améliorant le critère, on tend ainsi à chercher l'optimum dans le voisinage de l'état de départ. L'acceptation d'un état qui dégrade le critère de performance permet quant à lui d'explorer une plus grande partie de l'espace des états et tend à éviter de s'enfermer trop vite dans la recherche d'un optimum local.

En référence à la figure 2, au cours d'une première étape référencée E1, on procède à une initialisation de l'ensemble des paramètres du procédé. Cette étape d'initialisation est particulièrement délicate, car le choix de paramètres initiaux inadéquats peut entraîner des difficultés ou des lenteurs de convergence du procédé d'optimisation. Notamment, il est important de définir des paramètres initiaux, ou à tout le moins une méthode pour les initialiser, qui permette d'utiliser le principe du recuit simulé sur n'importe quel réseau électrique considéré, et ce, quelle que soit sa topologie.

On considère par exemple que l'on dispose d'un nombre de capteurs Nb_cap (3, 5 ou encore 10 capteurs) dont on souhaite optimiser le positionnement sur le réseau de la figure 1. Par exemple, Nb_cap=5.

Au cours de l'initialisation E1, on procède à une génération aléatoire d'une solution initiale $S_0$ de positionnement de ces Nb_cap capteurs dans le réseau 1. Cette solution initiale est associée à un vecteur représentatif des positions des capteurs au sein du réseau 1, par exemple [0, 123, 40, 77, 100]. La longueur du vecteur correspond au nombre de capteurs Nb_cap que l'on peut disposer dans le réseau 1, soit cinq dans cet exemple. Chaque composante du vecteur contient le numéro de l'un des noeuds du réseau 1 sur lequel on propose de placer un capteur selon cette solution, ces noeuds étant ordonnés dans le vecteur selon leur distance au noeud source « 0 ». Dans cet exemple, la solution associée au vecteur [0, 123, 40, 77, 100] correspond à une solution dans laquelle cinq capteurs sont respectivement placés sur les noeuds « 0 », « 123 », « 40 », « 77 » et « 100 » du réseau 1. Une telle structure de vecteur est bien adaptée au problème de l'optimisation du positionnement de capteurs dans un réseau de structure arborescente, notamment en ce qu'il permet de garder la structure topologique du réseau et d'en tirer parti dans la résolution du problème d'optimisation.

Au cours de cette étape d'initialisation E1, il convient également de fixer les valeurs de certains autres paramètres, tels qu'un paramètre de température initiale $T_0$ et un paramètre de température minimale $T_{min}$. Un mode de réalisation avantageux pour fixer ces valeurs sera décrit plus en détail ci-après.

Cette étape d'initialisation E1 étant réalisée, on évalue la performance de la solution initiale $S_0$ de positionnement des capteurs au cours d'une étape référencée E2.

En effet, afin de comparer les différentes positions de capteurs, il faut pouvoir évaluer leur performance afin de la maximiser, et ainsi obtenir la meilleure estimation d'état du réseau 1. En l'occurrence, on cherche à minimiser l'écart entre l'estimation d'état obtenue avec la position de capteurs donnée et une situation de référence obtenue via un « loadflow ». On rappelle qu'un loadflow est un calcul numérique des flux énergétiques dans un réseau électrique permettant d'obtenir la valeur d'une variable électrique, par exemple la tension sur tous les noeuds du réseau, ou les puissances actives et réactives sur chaque tronçon du réseau. Le loadflow est calculé en prenant en compte les consommations et productions des différents éléments du réseau ainsi que les caractéristiques des lignes, selon une technique connue de l'homme du métier que l'on ne détaillera donc pas ici plus avant.

Dans un mode de réalisation, le procédé d'optimisation de la figure 2 a pour objectif de minimiser la fonction objectif définie comme suit :

[Math. 1]

$$Perf(sol) = \sum_{n=1}^{N} \max \left( \left| \frac{loadflow(n) - estimation(n, sol)}{loadflow(n)} \right| \right)$$

où *Perf* désigne la performance de la solution *sol*, *N* le nombre de points de fonctionnement étudiés, et les fonctions *loadflow*(*n*) et *estimation*(*n, sol*) associent à chaque point de fonctionnement la tension des noeuds du réseau étudié calculée respectivement à l'aide d'un loadflow et d'une estimation d'état pour laquelle le placement des capteurs de tension est donné par la solution *sol.*

Dans un mode de réalisation, cette fonction objectif repose sur l'utilisation de points de fonctionnement, c'est-à-dire de niveaux de production et de consommation sur le réseau, intelligemment répartis sur les différents producteurs et charges du réseau. Dans un autre mode de réalisation, cette fonction objectif repose sur l'utilisation de N pas de temps.

On calcule ensuite la valeur absolue de l'écart relatif entre ces deux états du réseau, pour laquelle on garde l'écart relatif maximum. On somme enfin pour tous les points de fonctionnement ou pas de temps.

La position optimale des capteurs est celle qui minimisera cette fonction objectif.

Dans un mode de réalisation où l'on s'intéresse plus spécifiquement à la tension en chacun des noeuds du réseau 1, cette fonction objectif peut encore s'exprimer :

[Math. 2]

$$J = \sum_{i=0}^{N_p} max \left( \left( \frac{|V_n^i - V_{est,n}^i|}{V_n^i} \right)_{n=[0,1,\ldots,N_n]} \right)$$

Où $N_n$ désigne le nombre de noeuds du réseau, $N_p$ désigne le nombre de points de fonctionnement, Vn désigne la tension réelle au noeud n pour le point de fonctionnement i et $V_{est,n}^i$ désigne la tension estimée au noeud n pour le point de fonctionnement i.

Dans un autre mode de réalisation, on peut considérer uniquement l'erreur d'estimation commise sur les noeuds ayant des tensions qui s'éloignent le plus de la tension nominale, qui est de 1 p.u. (per unit). La fonction objectif peut alors s'exprimer :

[Math. 3]

$$J = \sum_{i=0}^{N_p} \sum_{j=0}^{N_n} \frac{|V_j^i - V_{est,j}^i|}{V_j^i} * \phi_j^i \left( \left( V_j^i \right)_{j \in [1,\ldots,N_n]} \right)$$

Où $N_n$ désigne le nombre de noeuds du réseau, $N_p$ désigne le nombre de points de fonctionnement, Vn désigne la tension réelle au noeud n pour le point de fonctionnement i et $V_{est,n}^i$ désigne la tension estimée au noeud n pour le point de fonctionnement i, et où :

[Math. 4]

$$\phi_j^i \left( \left( V_j^i \right)_{j \in [1,\ldots,N_n]} \right)$$

$$= \begin{cases} 1 \ si \ V_j^i \ si \ V_j^i \ est \ dans \ les \ 20\% \ des \ tensions \ qui \ s'éloignent \ le \ plus \ de \ 1 \ pour \ le \ point \ de \ fonctionnement \ i \\ 0 \ sinon \end{cases}$$

Une telle formulation de la fonction objectif a pour avantage d'optimiser le placement des capteurs, de façon à faire la meilleure estimation de tension possible là où la tension est la plus susceptible de sortir de la bande +/- 5% contractuelle. On rappelle en effet que dans le réseau de distribution électrique français, le gestionnaire du réseau doit s'assurer que la tension reste comprise dans une plage de +/- 5% autour d'une tension cible d'une majeure partie du réseau de 20kV.

Les trois équations ci-dessus permettent de calculer la performance, et donc l'énergie E, d'une solution de positionnement de capteurs, telle qu'évaluée par exemple lors de l'étape E2 pour la solution initiale. On notera $E_i$ l'énergie associée à la solution courante $S_i$.

L'objectif du recuit simulé est de se déplacer de proche en proche sur l'espace des solutions, en acceptant toujours un déplacement dans le voisinage qui améliore la performance, et en acceptant un déplacement dans le voisinage qui dégrade la performance avec une certaine probabilité décroissante au cours du temps, qui est fonction de la température.

Pour ce faire, on procède donc à une ou plusieurs itérations des étapes E3 à E7, jusqu'à ce que la température ait atteint la température limite fixée $T_{min}$ : on considère alors que l'on a convergé vers la solution optimale de positionnement des Nb_cap capteurs.

Au cours d'une étape référencée E3, on détermine donc une solution voisine de la solution courante (par exemple une solution voisine de la solution initiale $S_0$ pour la première itération de l'étape E3).

Pour ce faire, on considère l'ensemble des noeuds du réseau 1, qui est illustré sous forme schématique simplifiée sur la figure 3. On considère par exemple une solution courante Si=[m, n, p], selon laquelle Nb_cap= 3 capteurs sont respectivement positionnés sur les noeuds m, n et p du réseau 1, où m, n et p sont des entiers compris entre 0 et 152 dans l'exemple du réseau de la figure 1. On définit comme le voisinage d'un noeud l'ensemble constitué par ce noeud lui-même et tous les noeuds situés à une distance inférieure ou égale à un entier h de ce noeud, cette distance étant exprimée en nombre de noeuds. La valeur de h peut être choisie en fonction de la topologie du réseau considéré, et d'un compromis à atteindre entre une vitesse de convergence rapide du procédé d'optimisation et une convergence vers un optimum global et non local. Dans le mode de réalisation illustré en figure 3, on a choisi h=1. Ainsi, sur la figure 3, le voisinage du noeud m comprend le noeud m lui-même et ses voisins directs m1 et m2. Dans d'autres modes de réalisation, on pourrait aussi choisir h=2 ou h=3 par exemple.

En outre, si l'un des noeuds de ce voisinage est un noeud interdit (i.e. un noeud sur lequel il n'est pas possible de placer un capteur, par exemple parce que ce noeud reçoit déjà un Dispositif d'Echange d'Informations d'Exploitation (DEIE), installé chez les producteurs et permettant déjà une mesure de la tension, de la puissance active et de la puissance réactive), on complète le voisinage en y ajoutant les voisins directs du noeud interdit. Ainsi, le voisinage du noeud p comprend le noeud p lui-même et ses voisins directs p0 et p1 ; or, le noeud p0 est un noeud interdit. On étend donc le voisinage du noeud p pour y inclure le voisin direct du noeud interdit p0, à savoir le noeud p2. Le voisinage du noeud p, dans l'exemple de la figure 3, comprend donc les noeuds p, p1 et p2.

Dans la suite, on appelle voisin d'une position, un noeud situé dans le voisinage de cette position, tel que défini ci-avant. Pour construire une solution voisine à la solution courante Si=[m, n, p], on tire aléatoirement et de manière équiprobable un voisin de chaque position m, n et p. Ainsi, dans l'exemple de la figure 3 :

- le capteur placé en position m dans la solution courante Si aura 33% de chance d'être déplacé vers le noeud m1 dans la solution voisine de Si, 33% de chance d'être déplacé vers le noeud m2 dans cette solution voisine, et 33% de chance de ne pas être déplacé, et donc de rester sur le noeud m dans la solution voisine déterminée au cours de l'étape E3 ;
- de même, le capteur placé en position n dans la solution courante Si aura 50% de chance d'être déplacé vers le noeud n1 dans la solution voisine de Si, et 50% de chance de ne pas être déplacé, et donc de rester sur le noeud n dans la solution voisine déterminée au cours de l'étape E3 ;
- enfin, le capteur placé en position p dans la solution courante Si aura 33% de chance d'être déplacé vers le noeud p1 dans la solution voisine de Si, 33% de chance d'être déplacé vers le noeud p2 dans cette solution voisine, et 33% de chance de ne pas être déplacé, et donc de rester sur le noeud p dans la solution voisine déterminée au cours de l'étape E3.

Par exemple, au cours de l'étape E3, on détermine une solution voisine $S_{vois}$ de la solution courante Si telle que $S_{vois}$=[m, n1, p2]. Au cours de cette étape E3, on s'assure qu'au moins l'une des positions du vecteur solution change dans la solution voisine par rapport à la solution courante.

Au cours d'une étape référencée E4, on évalue la performance de la solution voisine $S_{vois}$, i.e. son énergie $E_{vois}$, en utilisant la même fonction objectif que celle utilisée pour évaluer la performance de la solution initiale lors de l'étape E2. On calcule également la variation d'énergie induite par le passage de la solution courante à la solution voisine :

[Math. 5]

$$\Delta E = E_{vois} - E_i$$

L'étape référencée E5 est une étape d'évaluation de cette variation d'énergie ΔE.

Si ΔE≤0, la solution voisine S$_{vois}$ est conservée comme nouvelle solution courante S$_{i+1}$ pour une nouvelle itération des étapes E3 et suivantes, puisqu'elle minimise l'erreur de l'estimation d'état du réseau.

Dans le cas contraire, si ΔE>0, la solution voisine S$_{vois}$ est conservée avec une probabilité égale à $e^{-\frac{\Delta E}{T_i}}$, où T$_i$ est la température à l'étape courante i, selon la règle dite de Metropolis.

Au cours d'une étape référencée E6, on compare la température courante à la température minimale déterminée à l'initialisation E1. Si la température minimale déterminée n'est pas atteinte, on diminue la température au cours d'une étape référencée E7, de sorte que $T_{i+1} = \alpha T_i$, où α est un coefficient déterminé et strictement inférieur à 1, par exemple α=0,99 ou α=0,95. Dans un mode de réalisation avantageux, on choisit α=0,97 lors de l'étape d'initialisation E1.

Les étapes E3 à E6 décrites ci-avant sont alors réitérées avec cette nouvelle valeur de température $T_{i+1}$, et l'on recommence à se déplacer dans le voisinage d'une solution courante.

En revanche, lorsqu'on détermine lors de l'étape E6 que la température courante a atteint la température limite fixée T$_{min}$, le procédé d'optimisation prend fin et l'on considère que l'on a convergé vers la solution optimale.

Dans ce cas, on procède au cours d'une étape référencée E8 au positionnement des capteurs dans le réseau 1, sur les noeuds dont les positions sont données par le vecteur de la dernière solution explorée lors des itérations des étapes E3 à E5.

Comme mentionné ci-avant, la convergence d'un tel procédé d'optimisation vers une solution optimale est délicate à obtenir et résulte d'un choix approprié des paramètres initiaux, lors de l'étape d'initialisation E1. On décrit ci-après un mode de réalisation avantageux de cette étape, qui permet d'utiliser simplement un tel procédé d'optimisation à base de recuit simulé sur n'importe quel réseau électrique.

Pour ce faire, au cours de l'étape E1, on procède au tirage aléatoire de k solutions, c'est-à-dire de k vecteurs de positionnement des Nb_cap capteurs. Par exemple, on choisit k=20, c'est-à-dire 20 ensembles de positions des Nb_cap capteurs.

On détermine un voisinage de chacune de ces k solutions, en utilisant la notion de voisinage définie ci-avant en relation avec l'étape E3 de la figure 2.

On évalue la performance de chacune des k solutions tirées aléatoirement, en utilisant l'une des fonctions objectifs proposées ci-avant en relation avec les équations Math. 1, Math. 2 et Math. 3 par exemple : on obtient ainsi l'énergie E$_{sol}$ de chacune de ces k solutions.

De même, on évalue la performance de chacune des solutions voisines à ces k solutions, pour obtenir l'énergie E$_{vois}$ de chacune de ces k solutions voisines.

On calcule alors un écart moyen espéré pour le recuit simulé sur l'ensemble des k solutions et de leurs voisines à partir de l'équation ci-dessous :

[Math. 6]

$$\Delta E_{esp} = \frac{\sum_1^k (E_{sol} - E_{vois})}{k}$$

Les températures initiale T$_0$ et finale T$_{min}$ sont ensuite choisies lors de cette étape d'initialisation E1, de sorte qu'au début des itérations ΔE « T et donc que la probabilité $e^{-\frac{\Delta E}{T}}$ d'accepter une solution qui dégrade le système soit proche de 1, ce qui permet de parcourir plus facilement l'ensemble des solutions, et donc d'éviter de converger trop rapidement vers un optimum local. Cela doit aussi permettre de faire en sorte qu'à la fin des itérations ΔE » T et donc que la probabilité $e^{-\frac{\Delta E}{T}}$ soit proche de 0, afin de converger vers l'optimum, i.e. la solution de positionnement des capteurs présentant une énergie minimale.

Dans un mode de réalisation qui donne des résultats satisfaisants, tant en termes d'atteinte de l'optimum que de temps de convergence, on choisit :

- T$_0$ = 100* $\Delta E_{esp}$ ;
- T$_{min}$ = 0,01 * $\Delta E_{esp}$ ;
- $\alpha$ = 0,97.

La solution initiale S$_0$ correspond à une position aléatoire des Nb_cap capteurs sur le réseau 1, et la température décroît selon la loi $T_{i+1} = \alpha T_i$.

La figure 4 illustre, sous la forme d'une courbe représentative de la règle de Metropolis, l'évolution au cours du temps (i.e. au fil de la décroissance de la température décidée au cours des étapes E7 successives) de la probabilité d'accepter un changement qui dégrade la valeur de la fonction objectif, dans le mode de réalisation décrit ci-avant à titre d'exemple.

Ainsi, à l'initialisation du procédé d'optimisation, pour les températures proches de la température initiale $T_0$, la probabilité $e^{\frac{-\Delta E}{T}}$ d'accepter une solution voisine qui dégrade la performance est proche de 1. En revanche, au fil du temps, la température décroît et s'approche de plus en plus de la température minimale $T_{min}$ : pour ces températures basses, les changements qui dégradent le système ont une très faible probabilité, proche de zéro, d'être acceptées, ce qui permet d'assurer la convergence du procédé d'optimisation.

Le procédé décrit ci-avant en relation avec les figures 1 à 4 a été testé sur une dizaine de réseaux électriques, avec des résultats reproductibles qui permettent de conclure que l'optimum est bien atteint.

Un exemple de positionnement optimal de capteurs obtenu par mise en oeuvre du procédé de la figure 2 selon un mode de réalisation est illustré en figure 5, sur laquelle le positionnement optimal des capteurs est indiqué par un triangle.

La figure 6 illustre schématiquement la structure d'un dispositif DIS d'optimisation du positionnement de capteurs dans un réseau électrique 1. Un tel dispositif DIS comprend un circuit de traitement connecté au réseau électrique pour la mise en oeuvre du procédé d'optimisation présenté ci-avant.

En référence à la figure 6, ce circuit de traitement peut comporter :

- une interface d'entrée IN de signaux reçus du réseau électrique, permettant au circuit de traitement de recevoir les données et informations sur le réseau, telles que la topologie du départ étudié, la position des capteurs déjà présents et des DEIE, ainsi que des données de production et de consommation sur le réseau 1,
- une mémoire MEM apte à stocker au moins temporairement des valeurs de tension, des vecteurs de solutions ainsi que leurs performances, ainsi que des données d'instruction d'un programme informatique pour la mise en oeuvre du procédé ci-avant. La mémoire MEM peut être de type ROM (de l'anglais « Read Only Memory ») ou RAM (de l'anglais « Random Access Memory ») ou encore Flash,
- un processeur PROC capable de coopérer avec la mémoire MEM et en particulier de lire les instructions stockées dans la mémoire pour exécuter notamment les étapes nécessaires à la mise en oeuvre du procédé défini ci-avant. Ainsi, le processeur PROC peut notamment calculer la performance des solutions et de leurs voisines, et procéder à la diminution de la température courante. Et
- une interface de sortie OUT coopérant avec le processeur PROC pour délivrer le résultat du procédé d'optimisation sous la forme d'une solution optimale de positionnement de capteurs, destinée à être restituée sur une interface homme/machine (affichage sur un écran par exemple), et pour envoyer des commandes CMD d'exécution d'un positionnement de capteurs selon la solution optimale restituée dans le réseau électrique.

La figure 6 illustre seulement une manière particulière, parmi plusieurs possibles, de réaliser un dispositif d'optimisation du positionnement de capteurs dans un réseau électrique, afin qu'il effectue les étapes du procédé détaillé ci-avant, en relation avec les figures 2 à 5 (dans l'un quelconque des différents modes de réalisation, ou dans une combinaison de ces modes de réalisation). En effet, ces étapes peuvent être réalisées indifféremment sur une machine de calcul reprogrammable (un ordinateur PC, un processeur DSP ou un microcontrôleur) exécutant un programme comprenant une séquence d'instructions, ou sur une machine de calcul dédiée (par exemple un ensemble de portes logiques comme un FPGA ou un ASIC, ou tout autre module matériel).

**Application industrielle**

Les présentes solutions techniques peuvent trouver à s'appliquer notamment dans tout réseau de distribution ou de transport d'électricité. Elles permettent de s'affranchir de la présence d'un expert pour prévoir une installation de capteurs, ce qui permet donc un gain de temps substantiel. En outre, les résultats obtenus lors de tests sur une dizaine de réseaux existants ont permis de confirmer une bonne convergence vers une solution optimale, même avec un nombre limité de capteurs (par exemple trois capteurs seulement pour un réseau de 150 noeuds environ), ce qui représente donc un gain financier important.

La mise en oeuvre de telles solutions d'optimisation permet de réaliser une estimation d'état optimale à nombre fixe de capteurs, ce qui permet de maximiser l'efficacité des leviers liés à l'estimation, comme les Fonctions Avancées de Réseau qui traitent de la tension (FAR-U), et donc un gain financier pour l'opérateur du réseau.

Il est également possible de réaliser plusieurs optimisations successives, avec des nombres de capteurs différents (par exemple, un, puis deux, puis trois capteurs, etc.) ; une analyse statistique sur les résultats obtenus avec ces différentes optimisations permet de déterminer le nombre de capteurs nécessaires optimum pour obtenir par exemple une précision à 1% sur l'estimation de la tension. On réalise alors une estimation d'état optimale à nombre de capteurs variable en incluant cette itération sur les capteurs et ce processus de validation.

**Liste des signes de référence**

- 1 : réseau électrique
- E1 : initialisation
- E2 : évaluation de performance
- E3 : détermination de solution voisine
- E4 : calcul de variation de performance
- E5 : évaluation de variation de performance
- E6 : test de température
- E7 : diminution de température
- E8 : placement de capteurs.

**Liste des documents cités**

**Documents brevets**

À toute fin utile, le(s) document(s) brevet(s) suivant(s) est (sont) cité(s) :

- patcit1 : FR 3 006 818 A1 (numéro de publication);
- patcit2 : CN107563550A (numéro de publication).

**Revendications**

1. Procédé d'optimisation du positionnement de capteurs dans un réseau électrique (1) comprenant un ensemble de noeuds (m, n, p), lesdits capteurs étant configurés pour fournir des mesures de variables électriques dudit réseau, ledit procédé comprenant :

  a. une initialisation (E1) du positionnement desdits capteurs, par tirage aléatoire d'une solution initiale correspondant à un ensemble de positions desdits capteurs au sein dudit ensemble de noeuds du réseau, et d'un paramètre de température initiale $T_0$,
  b. une évaluation (E2) d'une performance de ladite solution initiale, et
  c. au moins une itération d'évolution du positionnement desdits capteurs, produisant à partir d'une solution de positionnement de rang $i \geq 0$ une solution de positionnement de rang i+1, ladite évolution comprenant :

    i. une détermination (E3) d'une solution voisine de la solution de rang i, comprenant un ensemble de positions desdits capteurs choisies dans un voisinage des positions de la solution de rang i, un voisinage d'une position comprenant l'ensemble des noeuds situés à une distance inférieure ou égale à un de ladite position ;
    ii. une évaluation (E4) d'une performance de la solution voisine déterminée, et d'une différence, $\Delta E$, entre la performance de ladite solution voisine et la performance de la solution de rang i, et :

      1. si ladite différence $\Delta E$ est négative ou nulle, ladite solution voisine est conservée en tant que solution de positionnement de rang i+1 ;
      2. si ladite différence $\Delta E$ est positive, ladite solution voisine est conservée en tant que solution de positionnement de rang i+1 avec une probabilité égale à $e^{-\frac{\Delta E}{T_i}}$ , où $T_i$ est une valeur du paramètre de température au rang i ;

    iii. une diminution (E7) du paramètre de température selon l'équation $T_{i+1} = \alpha T_i$, où $\alpha$ est un coefficient déterminé et strictement inférieur à 1, tant que ledit paramètre de température est supérieur à un paramètre de température minimale déterminée $T_{min}$ ;

  et ledit procédé comprenant un placement (E8) desdits capteurs au sein dudit réseau aux positions déterminées par ladite solution de positionnement de rang i+1 obtenue à l'issue de ladite au moins une itération d'évolution.

2. Procédé d'optimisation selon la revendication 1, **caractérisé en ce que** ladite initialisation comprend :

- un tirage aléatoire de k≥2 solutions comprenant chacune un même nombre déterminé de capteurs ;
- une détermination d'une solution voisine de chacune des k solutions ;
- une évaluation d'une performance de chacune des k solutions, $E_{sol,k}$ et de chacune de leurs solutions voisines, $E_{vois,k}$ ;

- un calcul d'un écart moyen espéré selon l'équation : $\Delta E_{esp} = \frac{\sum_1^k (E_{sol,k} - E_{vois,k})}{k}$ ;

et **en ce que** ledit paramètre de température initiale est initialisé à $T_0 = 100 * \Delta E_{esp}$ et ledit paramètre de température minimale est déterminé par $T_{min} = 0,01 * \Delta E_{esp}$.

3. Procédé d'optimisation selon l'une quelconque des revendications 1 et 2, **caractérisé en ce que** ladite détermination (E3) d'une solution voisine de la solution de rang i comprend, pour chaque position dans la solution de rang i, un tirage aléatoire équiprobable d'une position située dans son voisinage, et **en ce que** ladite solution voisine diffère de la solution de rang i pour au moins une de ses positions.

4. Procédé d'optimisation selon l'une quelconque des revendications 1 à 3, , **caractérisé en ce que**, si ledit voisinage d'une position comprend au moins un noeud interdit, ledit voisinage de ladite position est complété par un voisinage dudit au moins un noeud interdit.

5. Procédé d'optimisation selon l'une quelconque des revendications 1 à 4, **caractérisé en ce que** ladite évaluation (E2, E4) d'une performance d'une solution met en oeuvre un calcul d'une fonction objectif définie par :

$$Perf(sol) = \sum_{n=1}^{N} \max \left( \left| \frac{loadflow(n) - estimation(n,sol)}{loadflow(n)} \right| \right)$$, où *Perf* désigne la performance de la solution *sol*, N est un nombre de points de fonctionnement étudiés, *loadflow*(n) associe à un point de fonctionnement *n* la valeur des variables électriques des noeuds dudit réseau calculées à partir de données de production et de consommation connues pour ledit réseau et *estimation*(n, sol) désigne pour le point de fonctionnement *n* la valeur des variables électriques des noeuds dudit réseau estimées à partir des mesures fournies par lesdits capteurs placés à l'ensemble de positions définies par la solution *sol* et **en ce qu'**une solution présente une performance d'autant meilleure qu'elle minimise la valeur de ladite fonction objectif calculée.

6. Programme informatique comportant des instructions pour la mise en oeuvre du procédé selon l'une des revendications 1 à 5 lorsque ce programme est exécuté par un processeur.

7. Support d'enregistrement non transitoire lisible par un ordinateur sur lequel est enregistré un programme pour la mise en oeuvre du procédé selon l'une des revendications 1 à 5 lorsque ce programme est exécuté par un processeur.

EP 4 564 631 A1

[Fig. 1]

[Fig. 2]

12

[Fig. 3]

[Fig. 4]

[Fig. 5]

[Fig. 6]

**EP 4 564 631 A1**

Europäisches Patentamt
European Patent Office
Office européen des brevets

# RAPPORT DE RECHERCHE EUROPEENNE

Numéro de la demande

EP 24 21 5019

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | FR 3 006 818 A1 (ELECTRICITE DE FRANCE [FR] ET AL.) 12 décembre 2014 (2014-12-12) * abrégé * * revendications 1,2,9,10 * * pages 2-4 * ----- | 1-7 | INV. H02J3/00 G01R31/08 H02J13/00 |
| A | CN 107 563 550 A (UNIV WUHAN) 9 janvier 2018 (2018-01-09) * abrégé * * alinéas [0006], [0010] - [0015] * * revendication 1 * ----- | 1-7 | |
| A | EP 4 142 086 A1 (SIEMENS SANAYI VE TICARET A S [TR]) 1 mars 2023 (2023-03-01) * abrégé * * alinéas [0001], [0003] - [0006] * * alinéas [0007], [0011] - [0014], [0022] * * alinéas [0035] - [0042], [0139], [0178] - [0181] * * revendications 1-17 * ----- | 1-7 | |
| | | | **DOMAINES TECHNIQUES RECHERCHES (IPC)** |
| A | EP 2 599 021 B1 (THALES SA [FR]) 22 mars 2017 (2017-03-22) * abrégé * * alinéas [0001], [0002], [0003], [0005], [0011] * * revendications 1,4,10 * ----- | 1-7 | H02J G01R |

Le présent rapport a été établi pour toutes les revendications

| Lieu de la recherche | Date d'achèvement de la recherche | Examinateur |
|---|---|---|
| Munich | 4 avril 2025 | Fiat, Cyrille |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

....................................................................
& : membre de la même famille, document correspondant

EPO FORM 1503 03.82 (P04C02)

15

# EP 4 564 631 A1

## ANNEXE AU RAPPORT DE RECHERCHE EUROPEENNE
## RELATIF A LA DEMANDE DE BREVET EUROPEEN NO.

EP 24 21 5019

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-04-2025

| Document brevet cité au rapport de recherche | | Date de publication | Membre(s) de la famille de brevet(s) | | Date de publication |
|---|---|---|---|---|---|
| FR 3006818 | A1 | 12-12-2014 | AUCUN | | |
| CN 107563550 | A | 09-01-2018 | AUCUN | | |
| EP 4142086 | A1 | 01-03-2023 | AUCUN | | |
| EP 2599021 | B1 | 22-03-2017 | EP | 2599021 A1 | 05-06-2013 |
| | | | FR | 2963454 A1 | 03-02-2012 |
| | | | IL | 224361 A | 28-02-2017 |
| | | | SG | 187263 A1 | 28-03-2013 |
| | | | US | 2013218499 A1 | 22-08-2013 |
| | | | WO | 2012013517 A1 | 02-02-2012 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- FR 3006818 A1

- CN 107563550 A